# EUROPEAN PATENT APPLICATION

(11) **EP 4 794 181 A1**
(43) Date of publication of application: **19.08.2026**
(21) Application number: 25157429.9
(22) Date of filing: 12.02.2025
(51) Int. Cl.: H02K 33/02, H02K 41/02

(54) **MAGNETIC Z-ACTUATOR AND WAFER HOLDER COMPRISING SUCH ACTUATOR**

(71) Applicant: ETEL S.A., 2112 Môtiers (CH)
(72) Inventor: Mittal, Manish, 2000 Neuchâtel (CH); Garcia-Herreros, Ivan, 2123 St. Sulpice (CH)
(74) Representative: P&TS SA (AG, Ltd.)

(57) **Abstract**

The invention relates to a magnetic Z-actuator (10) for payload positioning, with gravity compensation, comprising a stationary assembly (20) and a mobile assembly (40) configured to move relative to the stationary assembly (20). The stationary assembly (20) comprises a tubular magnetic yoke (21) and at least one upper permanent magnet (24a, 24b; 24) and at least one lower permanent magnet (25a, 25b; 25) mounted against an inner wall of said magnetic yoke (21) on top of each other. Each of the at least one upper and lower permanent magnets is either annular in shape, extending along the entire inner circumference of the magnetic yoke (21), or arcuate in shape, extending along a portion of the inner circumference. The at least one upper permanent magnet (24a, 24b; 24) has a radial magnetization opposite to that of the at least one lower permanent magnet (25a, 25b; 25). The mobile assembly (40) comprises a magnetic yoke (42), at least one permanent magnet (46a, 46b; 46), which is either annular in shape and positioned around the magnetic yoke (21) or arcuate in shape, covering a portion of the yoke's circumference, and at least one coil (44a, 44b; 44) mounted around said magnetic yoke (21). The stationary and mobile assemblies (20, 40) are configured to hold the payload in a stable position by counteracting gravity. The at least one coil (44a, 44b) is arranged to be energized such that the mobile assembly (40) is moved upwardly or downwardly relative to the stationary assembly (40). The present invention also concerns a wafer holder comprising the magnetic Z-actuator as well as a semiconductor equipment comprising such wafer holder.

## Description

### Technical domain

The present invention relates to a magnetic Z-actuator for semiconductor equipment in particular a wafer holder, comprising a stationary assembly and a mobile assembly adapted to move in a Z-direction relative to the stationary assembly. The Z-actuator comprises an adjustable gravity compensator to adjust the gravity counteracting force to adapt to the weight variation of the payload.

### Related art

In many applications, such as in the production of semiconductors, many wafer tables which are used to support and to process wafers are typically able to move in the vertical Z-direction. The weight of such wafer tables needs to be supported against the force of gravity by one or more gravity-compensation devices to reduce or eliminate the effect of the gravity force.

Conventional solutions typically consist of a passive gravity compensator unit combined with multiple voice coil motors, which significantly increase the system's bulk and complexity. For example, US 9,172,291 B2 discloses a magnetic Z-actuator with gravity compensation offering a more compact approach. However, a key limitation of this design lies in the gravity compensation force, which varies over the stroke due to its inherent negative stiffness. To counteract this issue, flexural elements with positive stiffness are introduced to stabilize the system. While effective in certain applications, these flexural elements impose structural constraints as the mobile assembly cannot move in the XY direction relative to the stationary assembly.

The use of flexural elements in such magnetic Z-actuator makes it incompatible with systems that require full six-degree-of-freedom (6 DoF) motion, such as wafer tables. This limitation arises because flexural elements, while effective in providing stiffness compensation, inherently restrict motion in certain degrees-of-freedom. By creating a stiff fixing between the stationary and mobile assemblies in these degrees-of-freedom, they also transmit disturbing forces causing vibrations of the payload. As a result, their use compromises the overall precision and stability required for high-performance positioning applications.

### Short disclosure of the invention

An aim of the present invention is to provide a magnetic Z-actuator for payload positioning, with gravity compensation, that overcomes the shortcomings and limitations of the state of the art.

More particularly, an aim of the present invention is to provide a magnetic Z-actuator with gravity compensation force that remains substantially constant over stroke.

Another aim of the present invention is to provide a high-precision magnetic Z-actuator compatible with systems requiring full six-degree-of-freedom motion.

A further aim of the present invention, according to some embodiments, is to provide a magnetic Z-actuator with adjustable gravity compensation as a function of the weight of the payload.

According to the invention, these aims are attained by the object of the attached claims, and especially by a magnetic Z-actuator for payload positioning, with gravity compensation, comprising a stationary assembly and a mobile assembly configured to move relative to the stationary assembly. The stationary assembly comprises a tubular magnetic yoke, at least one upper permanent magnet and at least one lower permanent magnet mounted against an inner wall of said magnetic yoke on top of each other. Each of the at least one upper and lower permanent magnets is either annular in shape, extending along the entire inner circumference of the magnetic yoke, or arcuate in shape, extending along a portion of the inner circumference. The at least one upper permanent magnet has a radial magnetization opposite to that of the at least one lower permanent magnet. The mobile assembly comprises a magnetic yoke, at least one permanent magnet, which is either annular in shape and positioned around the magnetic yoke or arcuate in shape, covering a portion of the yoke's circumference, and at least one coil mounted around said magnetic yoke. The stationary and mobile assemblies are configured to hold the payload in a stable position by counteracting gravity. The at least one coil is arranged to be energized such that the mobile assembly is moved upwardly or downwardly relative to the stationary assembly.

In an embodiment, the at least one upper permanent magnet comprises a first pair of two diametrically opposed arcuate permanent magnets while the at least one lower permanent magnet comprises a second pair of diametrically opposed arcuate permanent magnets. The magnets of each pair share the same radial magnetization whereas the second pair's radial magnetization is oriented in the opposite direction to that of the first pair.

In an embodiment, the first pair of two diametrically opposed arcuate permanent magnets is angularly aligned with the second pair of diametrically opposed arcuate permanent magnets.

In an embodiment, each arcuate permanent magnet of each pair extends over a range of 90° to 150°, preferably between 110° and 130°.

In an embodiment, the mobile assembly comprises two coils arranged on both sides of either one complete or incomplete annular-shaped permanent magnet or two diametrically opposed arcuate permanent magnets.

In an embodiment, each of said diametrically opposed arcuate permanent magnets extends over a range of 90° to 150°, preferably between 110° and 130°.

In an embodiment, the complete or incomplete annular-shaped permanent magnet or each of said diametrically opposed arcuate permanent magnets of the mobile assembly has a radial magnetisation.

In an embodiment, the magnetic Z-actuator further comprises a cylindrical housing. The tubular magnetic yoke is fitted inside the cylindrical housing so that it can be rotated relative to said housing and around the mobile assembly to adjust the gravity compensation force.

In an embodiment, the annular upper side of the tubular magnetic yoke comprises tool cooperating means for its rotation around the mobile assembly with a tool.

In an embodiment, the magnetic Z-actuator further comprises a clamp mounted on the cylindrical housing and arranged to press on the annular upper side of the tubular magnetic yoke to block it in a given angular position.

In an embodiment, the annular bottom side of the tubular magnetic yoke is resting against a shoulder provided on the inner wall of the cylindrical housing.

In an embodiment, one of the upper annular side of the cylindrical housing and of the upper annular side of the magnetic yoke of the stationary unit comprises at least one graduation extending over at least 40°, preferably over 60°. The other of the upper annular side of the cylindrical housing and upper annular side of the magnetic yoke of the stationary unit comprises at least one mark arranged to be moved along said graduation.

In an embodiment, one end of magnetic yoke of the mobile assembly is adapted to be connected to the payload.

Another aspect of the invention relates to a wafer holder comprising the magnetic Z-actuator according to any of the above embodiments.

Another aspect of the invention related to a semiconductor equipment comprising the above wafer holder.

### Short description of the drawings

Exemplar embodiments of the invention are disclosed in the description and illustrated by the drawings in which:
- Figure 1 shows a perspective view of the magnetic Z-actuator with an adjustable gravity compensator, according to an embodiment;
- Figure 2 shows a top view of the magnetic Z-actuator of Figure 1;
- Figure 3 shows an exploded view of the magnetic Z-actuator of Figure 1;
- Figure 4 shows a perspective view of the stationary assembly of the magnetic Z-actuator depicted in Figure 1, where the arcuate permanent magnets are represented in dashed lines;
- Figures 5 and 6 show perspective views of the stationary and mobile assemblies of the magnetic Z-actuator, respectively, without an adjustable gravity compensator, according to another embodiment;
- Figure 7 shows a schematic cross-sectional view of the magnetic Z-actuator, based on any of the above embodiments, illustrating its functional principle;
- Figure 8 depicts a chart illustrating a constant gravity compensation force over a stroke of the mobile assembly within a range of ±0.5 mm;
- Figure 9 depicts a chart illustrating the distribution of various forces based on the functional principle of the magnetic Z-actuator shown in Figure 7, plotted over the stroke of the mobile assembly;
- Figure 10 shows a simplified top view of the magnetic Z-actuator, as depicted in Figure 1, highlighting the adjustable angular angle between the stationary and mobile assemblies, and
- Figure 11 depicts a chart illustrating the variation of the gravity compensation force as a function of the angle shown in Figure 10.

### Examples of embodiments of the present invention

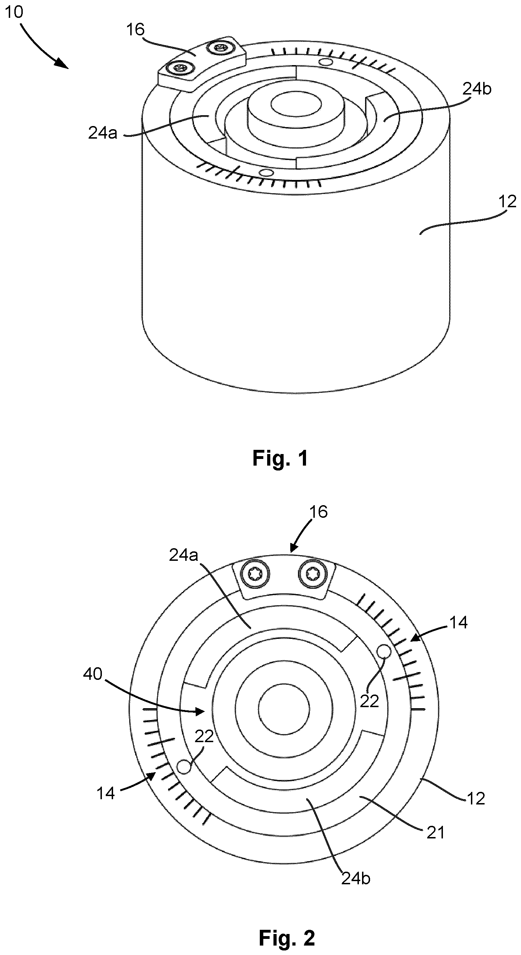

In a preferred embodiment, and with reference to Figures 1 to 3 and 7, the magnetic Z-actuator 10 for payload positioning is designed to provide gravity compensation, counteracting the force *F_{PL}* exerted by the weight of the payload. In this respect, the magnetic Z-actuator 10 comprises a stationary assembly 20 and a mobile assembly 40, which is mounted within the stationary assembly 20. As explained in detail below, the stationary and mobile assemblies include a set of permanent magnets arranged and positioned relative to each other to generate a counteracting force *F_{counter}* that sustains the payload in a stable position corresponding to an equilibrium state. The mobile assembly further comprises coils 44a, 44b which are adapted to be energized to move the mobile assembly upwardly or downwardly relative to the stationary assembly, as explained subsequently.

The magnetic Z-actuator 10 is particularly well-suited for semiconductor equipment, such as a wafer stage which is held by gravity compensation in the equilibrium state and wherein the coils 44a, 44b are energized for accurate positioning of the stage for example during wafer inspection, where the camera's shallow depth of field necessitates fine-tuning of the stage's vertical position to achieve autofocus.

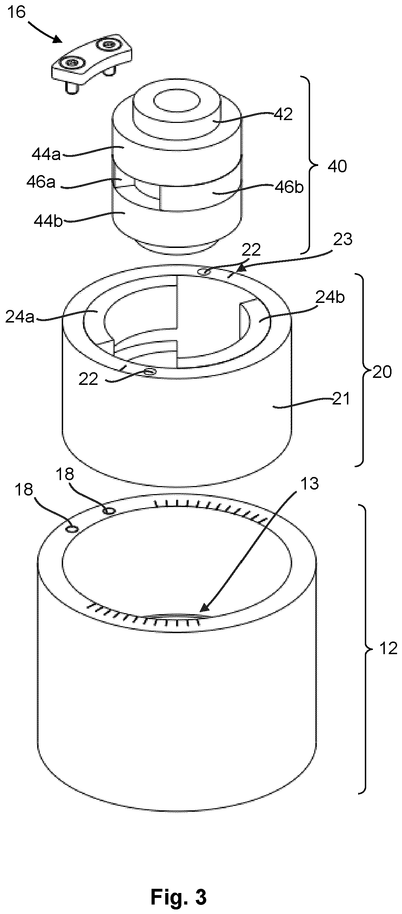

The stationary assembly 20 includes a tubular magnetic yoke 21 mounted inside a cylindrical housing 12, with its bottom side resting against a shoulder 13 (see Figure 3), which preferably extends around the entire inner circumference of the housing 12. The position of the annular shoulder 13 within the housing 12 and the height of the magnetic yoke 21 ensures that its upper annular side extends slightly above the upper annular side of the housing 12, for reasons explained further below.

In an advantageous aspect of this preferred embodiment lies on the angular adjustable positioning of the stationary assembly 20 relative to the mobile assembly 40 in order to vary to counteracting force *F_{counter}* according to the payload weight variation.

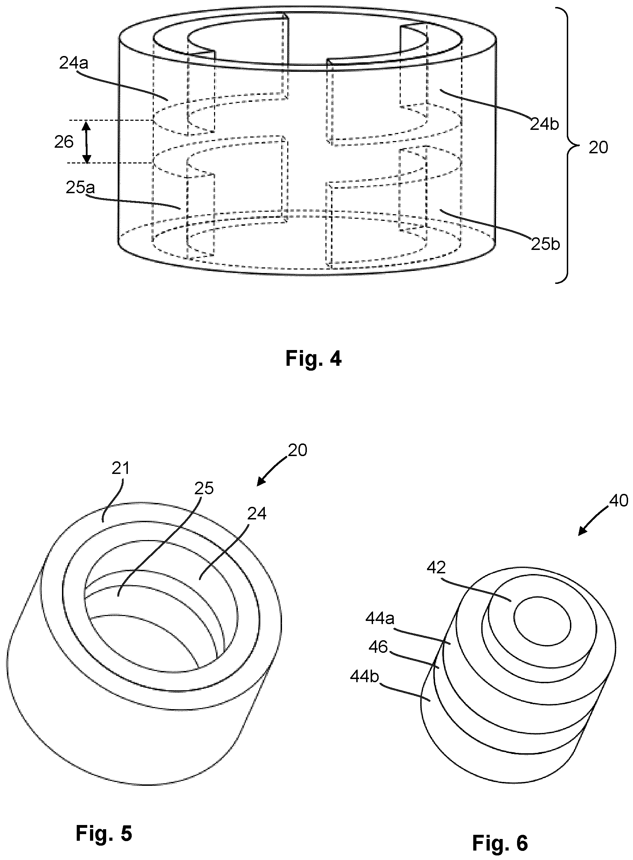

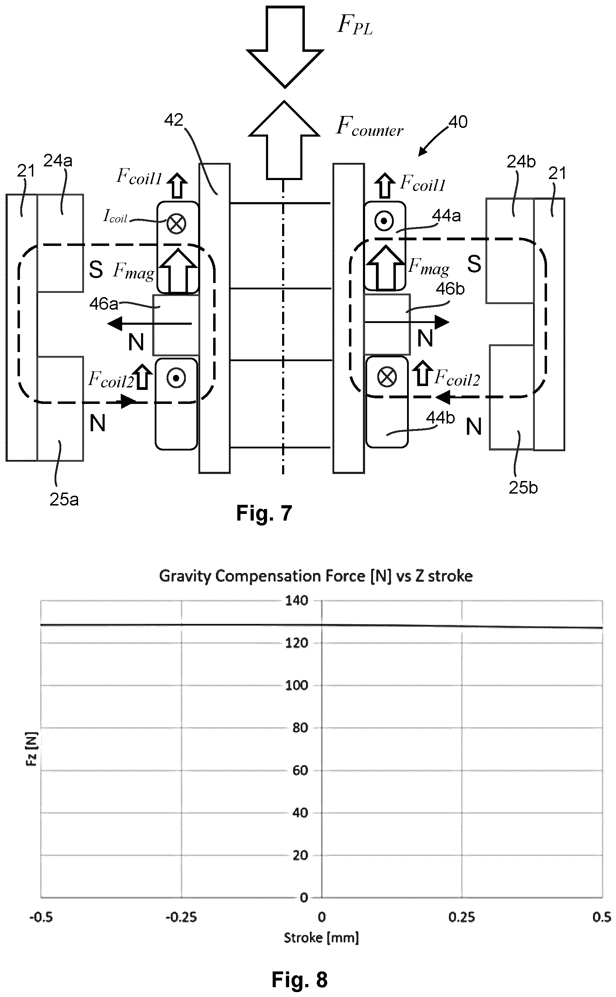

In this respect, referring to Figure 7, the magnetic yoke 21 includes a first pair and a second pair of arcuate permanent magnets 24a, 24b, 25a, 25b. The first pair of permanent magnets 24a, 24b are mounted against the upper inner wall portion of the magnetic yoke 21, positioned diametrically opposite each other. The second pair of permanent magnets 25a, 25b are mounted against the lower inner wall portion of the magnetic yoke, also diametrically opposed and aligned with the first pair. There is a gap 26 between the first and second pairs of permanent magnets (cf. Figure 4) at the level of the permanent magnets 46a, 46b of the mobile assembly 40.

The arcuate permanent magnets of each pair share the same radial magnetization while the radial magnetization of the first pair is oriented in the opposite direction to that of the second pair. For example, the first pair of diametrically opposed permanent magnets 24a, 24b has a positive radial magnetization, while the second pair of diametrically opposed permanent magnets 25a, 25b has a negative radial magnetization.

As particularly shown in Figure 2 and 4, each of the first pair of arcuate magnets 24a, 24b, as well as each of the second pair of arcuate magnets 25a, 25b, extends over a range of 90° to 150°, preferably between 110° and 130°, for example around 120°.

The mobile assembly 40 comprises a cylindrical or tubular magnetic yoke 42, two diametrically opposed arcuate permanent magnets 46a, 46b arranged around a middle portion of the magnetic yoke 42 and two coils mounted around the magnetic yoke 42 on both sides of the permanent magnets. Each of these two arcuate permanent magnets 46a, 46b has a positive radial magnetization and extends over a range between 90° and 150°, preferably between 110° and 130°, for example around 120°.

With reference to Figure 2, the annular upper side of tubular magnetic yoke 21 comprises tool cooperating means 22 for its rotation around the mobile assembly 40. The tool cooperating means may be for example in the form of two holes 22, diametrically opposed, so that two pins of a tool can be fitted into these holes for rotation of the stationary assembly 20 within the cylindrical housing 12 and relative to the mobile assembly 40.

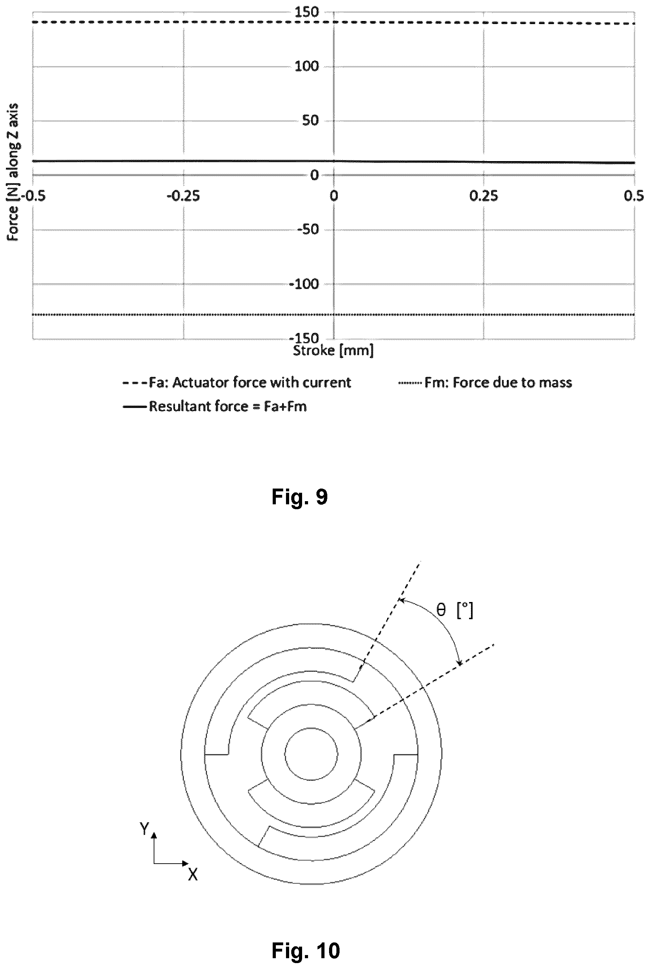

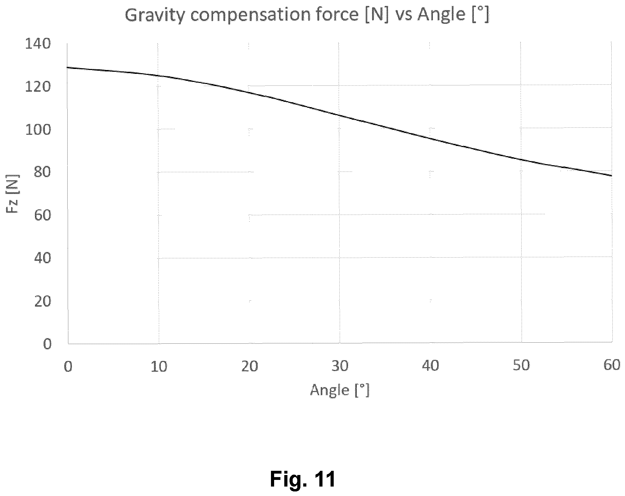

Referring to Figures 10 and 11, according to the designed described above, the maximal gravity counteracting force *F_{counter}* is set at 130 [N] and decrease down to 80 [N] for a relative angular movement of 60° between the stationary assembly 20 and the mobile assembly 40.

The magnetic Z-actuator 10 further comprises a clamp 16 mounted on the cylindrical housing 12 and arranged to press on the annular upper side of the tubular magnetic yoke 21, which is slightly higher than the housing top side, in order to block the magnetic yoke in a given angular position for the desired gravity counteracting force. The clamp 16 may comprise for example two screws fitted into two corresponding threaded holes 18 provided on the upper annular side of the housing 12 as shown in Figure 3.

The upper annular side of the cylindrical housing 12 further comprises two graduations diametrically opposed and extending each over at least 40°, preferably over 60°. The upper side of the tubular magnetic yoke 21 of the stationary unit 20 comprises two diametrically opposed marks 23 arranged to be moved along the corresponding graduation for precise adjustment of the gravity compensating force *F_{counter}.* These graduations may indicate the angle or force level.

According to a variant, these two graduations 14 are disposed in a diametrically opposed fashion along the upper annular side of the magnetic yoke 21 of the stationary unit 20 while the two marks 23 are disposed on the upper annular side of the cylindrical housing 12. In yet another variant, the housing 12 and the magnetic yoke 21 may comprise only one graduation and one mark respectively.

With reference to Figure 7, the upper end of the magnetic yoke 42 is adapted to be connected to the payload. The upper coil 44a, and lower coil 44b are energized to move the mobile assembly 40 in vertical direction upwardly or downwardly using Lorentz force. Since the gravity counteracting force *F_{counter}* compensates the payload weight that sustains a stable position corresponding to an equilibrium state, only a low current is required to move and keep position within the operating range. This limits Joule losses and heat generation in the coils and the overall system leading to high precision.

According to the illustrated embodiment, to move the mobile assembly 40 upwardly, the upper and lower coils 44a, 44b must be energized such that the current flows in a clockwise direction through the upper coil 44a and in an anticlockwise direction through the lower coil 44b. Conversely, to move the mobile assembly 40 downwardly, the upper and lower coils 44a, 44b must be energized such that the current flows in an anticlockwise direction through the upper coil 44a and in a clockwise direction through the lower coil 44b.

Figures 5 and 6 show the stationary assembly 20 and a mobile assembly 40 of a magnetic Z-actuator without an adjustable gravity compensator according to another embodiment. In this respect, the first and second permanent magnets 24, 25 are annular in shape, extending along the entire inner circumference of the magnetic yoke 21. The mobile assembly 40 comprises a permanent magnet 46 which is also annular in shape arranged in a middle portion of the magnetic yoke 42 between two coils 44a, 44b. The magnetic Z-actuator according to this embodiment is designed to maximize the gravity counteracting force, making it suitable for applications where the payload has substantial weight.

The magnetic interaction between the permanent magnets 46a, 46b of the mobile assembly 40 and the arcuate magnets 24a, 24b, 25a, 25b of the stationary assembly 20 generates a vertical force that contributes to gravity compensation. This vertical force remains constant over a specific range, ensuring stable support for the moving components. For instance, the Z-actuator of the illustrated embodiment provides a consistent gravity compensation force of 128N across a displacement range of ±0.5 mm, as illustrated in Figure 8.

Figure 9 illustrates the various forces acting on the magnetic Z-actuator in any of the aforementioned embodiments. The total force Fa generated by the actuator is a combination of the reluctance force and the Lorentz force, the latter being directly proportional to the current flowing through the coils. Additionally, the gravitational force Fm, which results from the mass of the moving assembly, must be compensated by the actuator to ensure stable operation.

Various modifications and variations to the described embodiments of the invention will be apparent to those skilled in the art without departing from the scope of the invention as defined in the appended claims. For example, le magnetic Z-actuator may comprise only one coil to drive the mobile assembly upwardly and downwardly.

### Reference signs

Z-actuator 10
Cylindrical-housing 12
   Shoulder 13
Graduation 14
   Clamp 16
   Holes 18
Stationary assembly 20
   Tubular magnetic yoke 21
   Holes 22
      Mark 23
   First pair of permanent magnets 24a, 24b
   Second pair of permanents magnets 25a, 25b
   Gap 26
Mobile assembly 40
   Magnetic yoke 42
   Coils 44a, 44b; 44
   Permanent magnet 46a, 46b; 46

## Claims

1. A magnetic Z-actuator (10) for payload positioning, with gravity compensation, comprising a stationary assembly (20) and a mobile assembly (40) configured to move relative to the stationary assembly (20), said stationary assembly (20) comprising a tubular magnetic yoke (21), at least one upper permanent magnet (24a, 24b; 24) and at least one lower permanent magnet (25a, 25b; 25) mounted against an inner wall of said magnetic yoke (21) on top of each other, wherein each of said at least one upper and lower permanent magnets is either annular in shape, extending along the entire inner circumference of the magnetic yoke (21), or arcuate in shape, extending along a portion of the inner circumference, said at least one upper permanent magnet (24a, 24b; 24) having a radial magnetization opposite to that of said at least one lower permanent magnet (25a, 25b; 25), wherein the mobile assembly (40) comprises a magnetic yoke (42), at least one permanent magnet (46a, 46b; 46), which is either annular in shape and positioned around the magnetic yoke (21) or arcuate in shape, covering a portion of the yoke's circumference, and at least one coil (44a, 44b; 44) mounted around said magnetic yoke (21), said stationary and mobile assemblies (20, 40) being configured to hold the payload in a stable position by counteracting gravity, and wherein said at least one coil (44a, 44b) is arranged to be energized such that the mobile assembly (40) is moved upwardly or downwardly relative to the stationary assembly (40).

2. The magnetic Z-actuator (10) according to claim 1, wherein said at least one upper permanent magnet comprises a first pair of two diametrically opposed arcuate permanent magnets (24a, 24b), wherein said at least one lower permanent magnet comprises a second pair of diametrically opposed arcuate permanent magnets (25a, 25b), wherein the magnets of each pair share the same radial magnetization, and wherein the second pair's radial magnetization is oriented in the opposite direction to that of the first pair.

3. **The magnetic** Z-actuator (10) according to the preceding claim, wherein the first pair of two diametrically opposed arcuate permanent magnets (24a, 24b) is angularly aligned with the second pair of diametrically opposed arcuate permanent magnets (25a, 25b).

4. The magnetic Z-actuator (10) according to claim 2 or 3, wherein each arcuate permanent magnet of each pair extends over a range of 90° to 150°, preferably between 110° and 130°.

5. The magnetic Z-actuator (10) according to any preceding claim, wherein the mobile assembly (40) comprises two coils (44a, 44b) arranged on both sides of either one complete or incomplete annular-shaped permanent magnet (46) or two diametrically opposed arcuate permanent magnets (46a, 46b).

6. The magnetic Z-actuator (10) according to the preceding claim, wherein each of said diametrically opposed arcuate permanent magnets (46a, 46b) extends over a range of 90° to 150°, preferably between 110° and 130°.

7. The magnetic Z-actuator (10) according to claim 5 or 6, wherein said complete or incomplete annular-shaped permanent magnet (46) or each of said diametrically opposed arcuate permanent magnets (46a, 46b) has a radial magnetisation.

8. The magnetic Z-actuator (10) according to any preceding claim, further comprising a cylindrical housing (12), wherein the tubular magnetic yoke (21) is fitted inside the cylindrical housing (12) so that it can be rotated relative to said housing and around the mobile assembly (40) to adjust the gravity compensation force (*F_{comp}*)*.*

9. The magnetic Z-actuator (10) according to the preceding claim, wherein the annular upper side of the tubular magnetic yoke (21) comprises tool cooperating means for its rotation around the mobile assembly (40).

10. The magnetic Z-actuator (10) according to claim 7 or 8, further comprising a clamp (16) mounted on the cylindrical housing (12) and arranged to press on the annular upper side of the tubular magnetic yoke (21) to block it in a given angular position.

11. The magnetic Z-actuator (10) according to any of claims 8 to 10, wherein the annular bottom side of the tubular magnetic yoke (21) is resting against a shoulder (13) provided on the inner wall of the cylindrical housing (12).

12. The magnetic Z-actuator (10) according to any of claims 8 to 10, wherein one of the upper annular side of the cylindrical housing (12) and of the upper annular side of the magnetic yoke (21) of the stationary unit (20) comprises at least one graduation extending over at least 40°, preferably over 60° and wherein the other of said upper annular side of the cylindrical housing (12) and upper annular side of the magnetic yoke (21) of the stationary unit (20) comprises at least one mark (23) arranged to be moved along said graduation.

13. The magnetic Z-actuator (10) according to any preceding claim, wherein one end of magnetic yoke (42) of the mobile assembly (10) is adapted to be connected to the payload.

14. A wafer holder comprising the magnetic Z-actuator (10) according to any preceding claim.

15. A semiconductor equipment comprising the wafer holder according to the preceding claim.
